Europäisches Patentamt

European Patent Office

Office européen des brevets

(19)

(11) Publication number: **0 349 318**
A2

# (12) EUROPEAN PATENT APPLICATION

(21) Application number: **89306610.0**

(22) Date of filing: **29.06.89**

(51) Int. Cl.⁵: **H 01 L 23/31**
**H 01 L 21/56**

(30) Priority: **01.07.88 GB 8815704**

(43) Date of publication of application:
**03.01.90 Bulletin 90/01**

(84) Designated Contracting States: **DE FR GB IT**

(71) Applicant: **GEC-Marconi Limited**
**The Grove Warren Lane**
**Stanmore Middlesex HA7 4LY (GB)**

(72) Inventor: **Tooze, Michael John**
**271 Robin Hood Lane Bluebell Hill**
**Rochester Kent (GB)**

(74) Representative: **Pope, Michael Bertram Wingate**
**Central Patent Department Wembley Office The General**
**Electric Company, p.l.c. Hirst Research Centre East Lane**
**Wembley Middlesex HA9 7PP (GB)**

(54) **Methods of making integrated circuit packages.**

(57) A method of making integrated circuit packages using tape automated bonding wherein the integrated circuit (3) and its leads (7) are provided with a moisture impervious coating (15) by deposition of material from an ambient atmosphere whilst the circuit is attached to the tape (11), before it is excised from the tape (11) and bonded to a substrate.

Fig.4.

EP 0 349 318 A2

Bundesdruckerei Berlin

## Description

### Methods of making Integrated Circuit Packages

This invention relates to methods of making integrated circuit packages.

More particularly the invention relates to methods of making integrated circuit packages using tape automated bonding (TAB).

TAB is a process in which a tape of plastics material, e.g. a polyimide, is provided with a series of apertures, normally rectangular, at spaced positions along the centre of the tape. A strip of metal, e.g. copper, foil is then bonded to one side of the tape and the foil etched to form around each aperture a lead pattern carried by the tape. The leads extend inwardly beyond the edge of the aperture and at their inner ends provide inner lead bonds which are positioned in corresponding manner to the connection pads of an integrated circuit chip. The leads extend outwardly from the inner lead bonds to provide adjacent the edge of the aperture outer lead bonds positioned in corresponding manner to connection pads on a substrate, e.g. a printed circuit board, on which it is desired to mount the chip. The leads normally extend outwardly beyond the outer lead bond area and terminate in test pads.

The prepared tape and a supply of chips are fed to an inner lead bonding machine wherein the inner lead bonds of each lead pattern are gang bonded to the connection pads of a respective chip. The tape with chips so attached is then fed to an outer lead bonding machine wherein each chip with its lead pattern attached is excised from the tape and the outer lead bonds of each lead pattern bonded to a respective set of connection pads on a substrate. To facilitate inner lead bonding the inner lead bonds or the chip connection pads are normally provided with so called bumps e.g. of gold.

The TAB process results in the production of chips possessing high packaging density with an increased chip yield due to ease of test which adds value to the chips.

The chips moreover have high bond strength and bond reliability and are producible at reduced cost due to elimination of secondary packaging i.e. packaging intended to protect the integrated circuit during the manufacturing process.

Realisation of the above benefits has been difficult to achieve for high reliability systems because of the need in such systems for hermetic encapsulation to provide environmental protection. This has restricted the use of TAB mounted chips to assembly onto hybrid substrates, e.g. ceramic substrates to provide a base for a hermetic lid rather than directly onto circuit cards. This detracts from the savings as the ceramic package may be considered as merely another form of secondary package requiring its own connections and thermal path onto a fixed circuit board assembly.

It is an object of the present invention to provide a method of making integrated circuit packages using TAB wherein this difficulty is overcome.

According to the present invention there is provided a method of making integrated circuit packages using tape automated bonding wherein after bonding of each integrated circuit to a lead pattern on a tape a coating of moisture impervious material is formed on all exposed surfaces of the integrated circuit and its lead pattern by deposition from an ambient atmosphere.

The material suitably comprises a nitride material.

Deposition of the coating is suitably effected by magnetron sputtering or by microwave plasma assisted chemical vapour deposition.

One method in accordance with the invention will now be described by way of example with reference to the accompanying drawings in which:-

Figures 1 and 2 are diagrams illustrating alternative possible forms of the inner lead bonds and chip connection pads in conventional TAB processes; and

Figures 3 and 4 are diagrams illustrating two stages in the method according to the invention.

A tape carrying a lead pattern for use in a TAB process for making integrated circuit packages is first prepared in conventional manner.

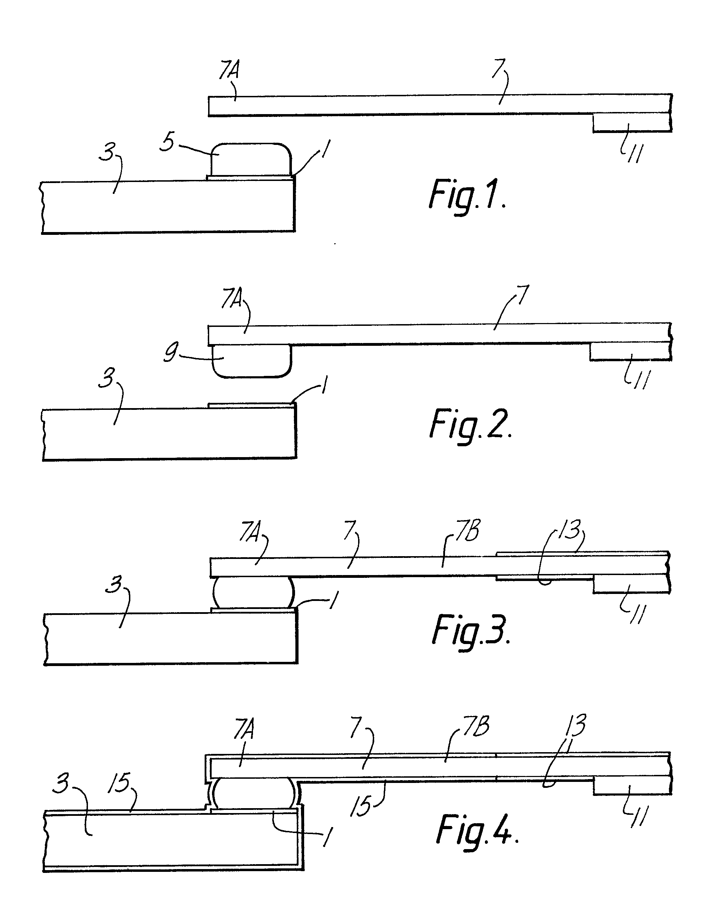

Referring to Figure 1, the connection pads 1 of the integrated circuit chips 3 may be provided with gold bumps 5 or alternatively the inner ends 7A, i.e. inner lead bonds of the leads 7 of the lead pattern, may be provided with gold pads 9, as shown in Figure 2.

The tape 11 together with a supply of chips 3 is fed to an inner lead bonding machine (not shown) of conventional form and the inner lead bonds 7A bonded to the connection pads 1 on the chips 3, as shown in Figure 3.

The outer lead bonds 7B of the leads 7 and the test pads (not shown) of the lead pattern, if present, are then provided with a protective coating 13, e.g. of wax, as shown in Figure 3.

The tape 11 with the chips 3 attached is then passed through a chamber (not shown) wherein the exposed surfaces of the chips 3 and leads 7 are provided with a coating of a nitride material 15 by deposition from an ambient atmosphere. The nitride material is any electrical insulating nitride material impervious to moisture such as a nitride of aluminium, boron silicon, germanium, gallium or indium.

After removal of the protective coating 13, e.g. with a solvent, the tape 11 is fed to an outer lead bonding machine (not shown) wherein each chip 3 is excised from the tape 11 and bonded to a substrate 5 (now shown) in conventional manner.

The nitride coating 15 is suitably deposited using a DC magnetron sputtering technique. Alternatively the coating 15 may be deposited using a microwave plasma assisted chemical vapour deposition process. The latter comprises microwave heating of a mixture of nitrogen and the necessary precursor chemical vapours required to form a plasma from which the nitride coating is deposited.

In general magnetron sputtering is cheaper than plasma deposition but affords less control over the composition of the nitride coating.

It will be appreciated that the nitride coating forms an encapsulating coating impervious to water and salt ions present in water and other solvents liable to cause contamination and so reduce reliability of the chip.

The gaseous nature of the deposition process is such that a uniform layer of material is provided of a few micrometers in thickness which contributes to the strength of the bond between the coating and the chip and its leads. Furthermore the nature of the deposition process is such as to have no material effect on the thermal or mechanical properties of the chip.

It will be appreciated that a method according to the invention allows the use of a TAB process to mount integrated circuit chips directly on a substrate without the need for secondary packaging betwen the integrated circuit and substrate when environmental protection for the integrated circuit is required.

## Claims

1. A method of making integrated circuit packages using tape automated bonding wherein after bonding of each integrated circuit (3) to a lead pattern (7) on a tape (11) a coating (15) of moisture impervious material is formed on all exposed surfaces of the integrated circuit (3) and its lead pattern (7) by deposition from an ambient atmosphere.

2. A method according to Claim 1 wherein said material is a nitride material.

3. A method according to Claim 1 or Claim 2 wherein deposition of the coating is effected by magnetron sputtering.

4. A method according to Claim 1 or Claim 2 wherein deposition of the coating is effected by microwave plasma assisted chemical vapour deposition.

7A          7

3    5        1

Fig.1.

11

7A          7

9

3        1

Fig.2.

11

7A    7    7B    13

3        1

Fig.3.

11

7A    7    7B    13

3    15

15        1

Fig.4.

11